# FASCICULE DE BREVET EUROPEEN

(11) **EP 2 514 284 B1**
(45) Date de publication et mention de la délivrance du brevet: **26.02.2014**
(21) Numéro de dépôt: 10790767.7
(22) Date de dépôt: 10.12.2010
(51) Int. Cl.: H05K 5/00, G06K 19/077, G06K 19/07

(54) **SYSTEME DE DIALOGUE HOMME-MACHINE**
MENSCH-MASCHINE-DIALOGSYSTEM
MAN/MACHINE DIALOGUE SYSTEM

(30) Priorité: 18.12.2009 FR 0959172
(43) Date de publication de la demande: 24.10.2012
(73) Titulaire: Schneider Electric Industries SAS, 92500 Rueil-Malmaison (FR)
(72) Inventeur: CHAUVET, Francis, F-16440 Mouthiers (FR); BENNI, Dominique, F-16600 Mornac (FR); TARDIVON, Alain, F-16170 Gourville (FR)
(74) Mandataire: Bié, Nicolas
(86) Numéro de dépôt international: PCT/EP2010/069415
(87) Numéro de publication internationale: WO 2011/073108

(56) Documents cités:
- WO-A1-2008/038896
- US-A1- 2008 007 408
- US-A1- 2009 167 495
- US-B1- 6 445 585

## Description

La présente invention se rapporte à un système de dialogue homme-machine. L'invention concerne plus précisément un système de dialogue homme-machine qui fonctionne par couplage magnétique entre une station de lecture/écriture RFID et plusieurs organes de dialogue homme-machine.

La présente invention utilise donc le principe de l'identification par radio-fréquence, appelée aussi RFID (Radio Frequency Identification), qui permet à une station de lecture/écriture RFID (appelée aussi station RFID ou lecteur RFID) de pouvoir échanger des données avec une ou plusieurs étiquettes électroniques RFID (appelée également transpondeur, tag ou smart label) lorsqu'elles sont placées à proximité de la station RFID dans une zone appelée ci-après zone de dialogue de la station.

De manière connue, une station de lecture/écriture RFID possède une antenne formée par un circuit oscillant dans lequel on peut créer ou capter un champ magnétique qui permet une communication sans fil par couplage magnétique (appelé aussi couplage inductif) avec tout circuit oscillant placé dans une zone de dialogue de la station, par exemple avec l'antenne d'une étiquette électronique RFID. Généralement, les données binaires sont échangées entre une station et une étiquette par une modulation en amplitude et/ou en phase de la fréquence porteuse du signal magnétique.

Une étiquette électronique RFID est ainsi capable de recevoir un signal radio et de renvoyer en réponse un signal différent contenant une information pertinente. Elle possède une mémoire qui permet de stocker diverses informations d'identification, de reconnaissance et/ou de process. Certaines étiquettes permettent uniquement une lecture de données préalablement stockées lorsqu'une station est placée à proximité mais d'autres permettent en plus une écriture des données (écriture unique ou multiple) stockées dans l'étiquette.

Par ailleurs, dans le cas d'une étiquette dite passive, le signal électromagnétique (porteuse) créé par l'antenne de la station RFID sert également à alimenter électriquement l'étiquette lorsque celle-ci est dans la zone de dialogue de la station. L'énergie captée par l'antenne de l'étiquette est en effet transformée en énergie électrique qui alimente les circuits internes (mémoire, unité de traitement,...) de cette étiquette. En s'alimentant avec l'énergie produite par le champ électromagnétique de la station, l'étiquette présente donc l'avantage de ne pas nécessiter d'alimentation interne telle qu'une pile ou une batterie.

Il est connu du document US 6,285,295 un système de dialogue homme-machine comportant un clavier et une station RFID. Le clavier comporte une pluralité de touches, chaque touche étant associée à un interrupteur et à une étiquette électronique passive de type RFID qui comporte des moyens de traitement et une mémoire interne. Les étiquettes associées à chaque touche du clavier sont connectées en parallèle à une antenne commune. La mémoire interne de chaque étiquette stocke un identifiant unique. La pression d'une touche du clavier entraîne la fermeture de l'interrupteur correspondant et la connexion de l'étiquette à l'antenne commune. Par l'intermédiaire de cette antenne, l'étiquette est alors alimentée par la station et son identifiant unique peut alors être envoyé à la station.

Un système de dialogue homme-machine est également décrit dans le document US2009/128337. Dans ce système, chaque touche d'un clavier est associée à une étiquette électronique qui comporte sa propre antenne. Selon la position de la touche, l'étiquette se trouve ou non dans la zone de dialogue de la station de lecture. Lorsqu'une touche est pressée, l'étiquette électronique associée à cette touche se rapproche de la station et peut alors être lue par la station. Lorsque cette touche est relâchée, son étiquette électronique sort du champ de la station et ne peut alors plus être lue.

Dans le système décrit dans le premier document antérieur, une pression sur une touche entraîne donc la connexion de l'étiquette à l'antenne et dans le système décrit dans le second document, la pression sur la touche permet à l'étiquette d'entrer dans la zone de dialogue de la station. Ces deux systèmes sont donc appropriés pour des organes de dialogue homme-machine de type bouton marche-arrêt car la station de lecture ne peut lire la mémoire de l'étiquette que lorsque la touche est pressée. Ces modes de fonctionnement ne peuvent être employés pour d'autres types d'organes de dialogue homme-machine qui comportent par exemple des organes de signalisation ou des organes de commande plus complexes à plus de deux positions.

Il est également connu du document US2008/007408 un dispositif de détection comportant un circuit sur lequel sont positionnés en série un interrupteur commandé et une étiquette RFID. Selon l'état de l'interrupteur, l'étiquette RFID envoie un message différent représentatif de l'état de l'interrupteur.

Les documents W02008/038896 et US2009/167495 décrivent tous deux une étiquette électronique de type RFID comportant une LED commandée et alimentée via les circuits internes de l'étiquette.

Le but de l'invention est de proposer un système de dialogue homme-machine dans lequel la station peut être associée à différents types d'organes de dialogue homme-machine.

Ce but est atteint par un système de dialogue homme-machine comportant :
- une station de lecture/écriture de type RFID incluant notamment des moyens de traitement de données,
- une antenne connectée ou couplée magnétiquement à la station de lecture/écriture,
- plusieurs organes de dialogue homme-machine comportant chacun une interface de dialogue homme-machine et une étiquette électronique,
- l'étiquette électronique étant dotée d'une mémoire interne et de moyens de traitement et étant positionnée de manière à être alimentée par couplage magnétique par la station de lecture/écriture et à communiquer sans contact par couplage magnétique avec la station de lecture/écriture,
- la mémoire interne de l'étiquette électronique stockant des données représentatives d'un état de l'organe de dialogue homme-machine, et
- la station comportant des moyens de lecture/écriture de la mémoire interne de l'étiquette électronique,
- le système comportant un support de fixation destiné à accueillir chaque organe de dialogue homme-machine de manière amovible et interchangeable, conférant au système une grande modularité.

Selon une particularité, l'organe de dialogue homme-machine comporte une interface de commande actionnable par un utilisateur et coopérant avec les moyens de traitement de l'étiquette électronique pour écrire des données représentatives de l'état de l'organe de dialogue homme-machine dans la mémoire de l'étiquette électronique.

Selon une autre particularité, l'organe de dialogue homme-machine comporte une interface de signalisation connectée à l'étiquette de manière à pouvoir être alimentée par le couplage magnétique existant entre la station et l'étiquette et coopérant avec les moyens de traitement de l'étiquette électronique pour afficher l'état correspondant aux données stockées dans la mémoire interne de l'étiquette électronique.

Selon une autre particularité, l'organe de dialogue homme-machine comporte une interface d'identification ou de détection coopérant avec les moyens de traitement de l'étiquette électronique pour écrire des données représentatives de l'état de l'organe de dialogue homme-machine dans la mémoire de l'étiquette électronique.

Selon une autre particularité, l'antenne est intégrée au support de fixation.

Selon une autre particularité, le support de fixation comporte un blindage agencé pour limiter la zone de dialogue existant entre la station et les étiquettes électroniques.

Selon une autre particularité, le support de fixation et la station sont positionnés de part et d'autre d'une paroi.

Selon une première variante de réalisation, le support de fixation comporte une plaquette destinée à recevoir par coulissement plusieurs organes de dialogue homme-machine.

Selon une seconde variante de réalisation, le support de fixation comporte une tige sur laquelle sont enfilés les organes de dialogue homme-machine. Selon une particularité, l'antenne est par exemple intégrée à la tige du support de fixation.

Selon une autre particularité de l'invention, le système comporte un ensemble comprenant un organe d'émission/réception sans-fil de données et une étiquette électronique, ledit ensemble étant apte à être positionné sur le support de fixation.

D'autres caractéristiques et avantages vont apparaître dans la description détaillée qui suit en se référant à un mode de réalisation donné à titre d'exemple et représenté par les dessins annexés sur lesquels :
- la figure 1 représente, en vue en perspective, un système de dialogue homme-machine conforme à l'invention,
- la figure 2 représente, en vue éclatée, le système de dialogue homme-machine de la figure 1,
- la figure 3A représente, en coupe axiale longitudinale, le système de dialogue homme-machine de la figure 1,
- la figure 3B représente un détail de la figure 3A,
- la figure 4 représente, en coupe axiale transversale, le système de dialogue homme-machine de la figure 1,
- la figure 5 représente de manière schématique l'architecture de fonctionnement d'un organe de dialogue homme-machine doté d'une interface de commande de type bouton-poussoir et d'une étiquette électronique de type RFID,
- la figure 6 représente de manière schématique l'architecture de fonctionnement d'un organe de dialogue homme-machine doté d'un voyant lumineux et d'une étiquette électronique de type RFID,
- la figure 7 représente de manière schématique une variante de réalisation d'un système de dialogue homme-machine conforme à l'invention,
- les figures 8A et 8B représentent de manière schématique différentes configurations de fonctionnement de l'invention.

Dans la suite de la description, pour des raisons de simplicité, certains éléments conservent une même référence numérique dans les différents modes de réalisation décrits.

L'invention concerne un système de dialogue homme-machine comportant notamment une station de lecture/écriture 1 de type RFID et plusieurs organes de dialogue homme-machine 2 qui comporte une interface de dialogue homme-machine 20 et une étiquette électronique 21 de type RFID.

Par station de lecture/écriture 1 de type RFID, on entend une station capable de lire et éventuellement d'écrire des données dans une mémoire d'une étiquette électronique 21 RFID. Dans la technologie RFID, lorsqu'une étiquette électronique 21 est dans le champ d'action ou zone de dialogue de la station 1 et que la station 1 émet un signal électromagnétique, il y a couplage magnétique entre l'étiquette 21 et la station 1, l'antenne 6 de la station 1 et l'antenne 25 de l'étiquette pouvant être considérées comme le primaire et le secondaire d'un transformateur. L'étiquette 21 répond au signal émis par la station 1 et un dialogue peut s'établir, les informations étant échangées par modulation d'amplitude, de fréquence ou de phase sur la fréquence porteuse. La valeur de la fréquence de la porteuse d'émission peut être choisie dans une zone dite de basses fréquences (par exemple 125 KHz) ou préférentiellement de hautes fréquences (par exemple 13,56 MHz). Dans ces deux cas, le système fonctionne en couplage magnétique en champ proche, c'est-à-dire habituellement avec une portée de l'ordre de quelques centimètres à quelques dizaines de centimètres suivant l'énergie disponible. De façon connue, une antenne est formée par une inductance associée éventuellement à une résistance et une capacité pour adapter l'impédance de l'antenne et accorder la fréquence de porteuse souhaitée.

Dans la suite de la description, par interface de dialogue homme-machine 20, on entend toute interface de commande actionnable manuellement ou par un élément externe et actionnable directement ou à distance par liaison filaire ou sans-fil. Cela inclut donc par exemple les différents types de bouton tels que bouton poussoir, bouton tournant à au moins deux positions mais aussi les capteurs de position et d'autres types d'interfaces de commande tels que les écrans tactiles.

Par interface de dialogue homme-machine 20, on entend également toute interface de signalisation visuelle ou sonore, couplée ou non à une interface de commande. Cela inclut donc par exemple les voyants lumineux, les étiquettes lumineuses ou les écrans d'affichage, de même que tous les avertisseurs sonores. Selon l'invention, l'interface de signalisation employée est alimentée par l'énergie captée par l'antenne 25 de l'étiquette 21 grâce au couplage magnétique existant avec la station 1.

Par interface de dialogue homme-machine 20, on entend également toute interface de détection ou d'identification couplée ou non à une interface de signalisation ou à une interface de commande telle que définie ci-dessus. Cela inclut donc par exemple tout capteur de présence de type capacitif, inductif ou résistif de même que tout capteur de type biométrique permettant d'identifier une personne.

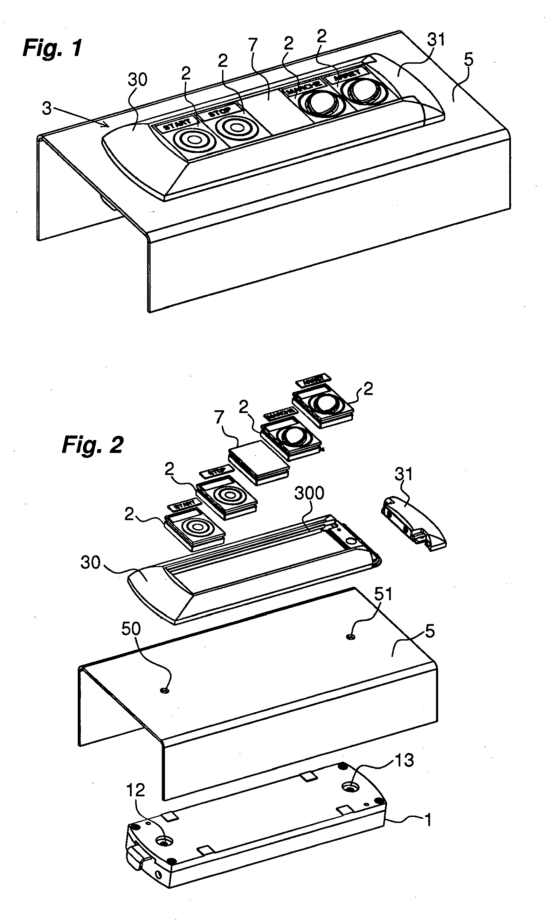

Dans la suite de la description, il faut comprendre que l'organe de dialogue homme-machine 2 peut comporter lui-même plusieurs interfaces de dialogue homme-machine 20 différentes telles que décrites ci-dessus (voir figure 1). Ainsi, l'organe de dialogue homme-machine 2 pourra comporter à la fois une interface de commande telle que par exemple un bouton poussoir et une interface dé signalisation telle que par exemple un voyant lumineux.

Selon l'invention, le système de dialogue homme-machine peut comporter, en plus de plusieurs organes de dialogue homme-machine 2, un ensemble 7 (figures 1 et 2) comportant un organe d'émission/réception de données par technologie sans-fil (radio, infrarouge...) et une étiquette électronique de type RFID. Dans la suite de la description, il faut comprendre que le système de dialogue homme-machine de l'invention peut également intégrer ce type d'ensemble. Cet ensemble peut notamment être associé sur le système à plusieurs organes de dialogue homme-machine 2 tels que décrits ci-dessus.

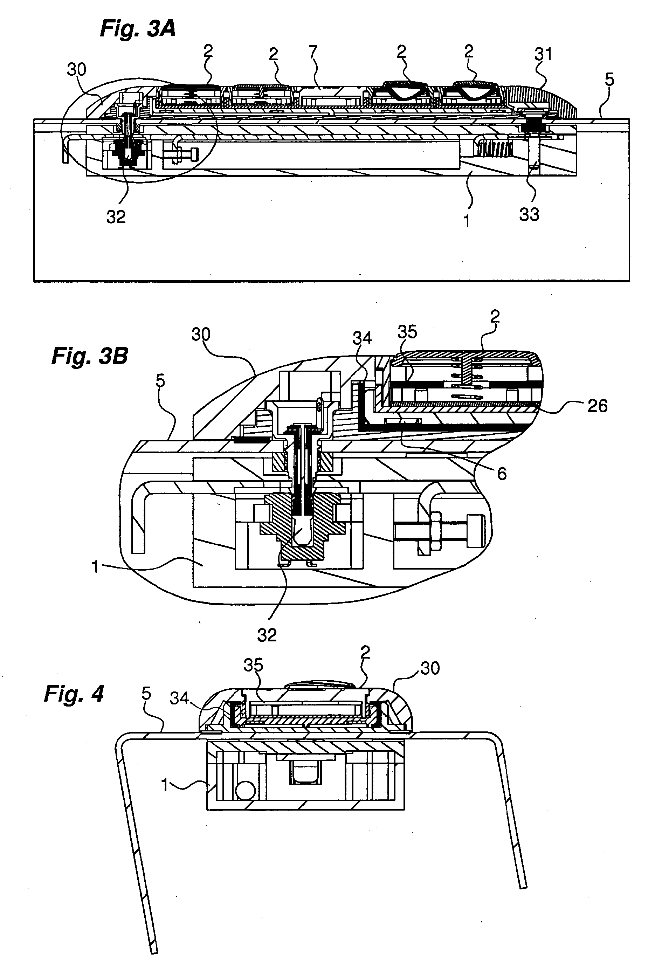

Selon l'invention, chaque étiquette électronique 21 est associée à une interface de dialogue homme-machine 20 telle que définie ci-dessus. Les deux éléments sont par exemple associés dans un même boîtier de manière à former un ensemble monobloc. Les composants électroniques de chaque organe de dialogue homme-machine 2 sont par exemple connectés sur un même circuit imprimé 26 intégré au boîtier de l'organe 2 (figure 3B).

De manière connue, une étiquette électronique 21 de type RFID Chaque étiquette électronique présente un identifiant unique et comporte une antenne 25 constituée d'un circuit oscillant LC et des circuits électroniques comprenant notamment une mémoire 23 et des moyens de traitement 22 de données pour interpréter les requêtes envoyées par la station de lecture/écriture 1 et pour envoyer les informations demandées. L'étiquette électronique 21 est alimentée par la "porteuse" émise à partir de l'antenne de la station dès qu'elle entre dans les limites de portée de ladite station de lecture/écriture. L'énergie captée par l'antenne 25 de l'étiquette est transformée en énergie électrique, celle-ci étant stockée dans des moyens de stockage d'énergie 24 en vue d'alimenter les circuits électroniques internes de l'étiquette 21. L'étiquette électronique 21 mémorise des données, exécute les ordres en provenance de la station de lecture/écriture 1 et transmet les données demandées vers la station de lecture/écriture 1.

La mémoire 23 contenue dans l'étiquette électronique 21 est à titre indicatif une mémoire de technologie RAM, EEPROM ou FERAM et stocke notamment des données représentatives de l'état de l'organe de dialogue homme-machine 2 auquel elle est associée. La mémoire 23 de l'étiquette électronique peut également stocker des données relatives au type d'interface de dialogue homme-machine 20 à laquelle l'étiquette 21 est associée.

Selon l'invention, l'identifiant unique de chaque étiquette 21 est appris par la station 1 lors d'une étape préalable d'apprentissage et est associée dans la mémoire de la station au type d'interface de dialogue homme-machine 20 correspondant à l'étiquette 21. La station 1 configure ensuite ses entrées-sorties en fonction du type d'interface de dialogue homme-machine 20 à adresser.

Selon le type d'interface de dialogue homme-machine 20 employé, la configuration de l'organe de dialogue homme-machine 2 peut varier.

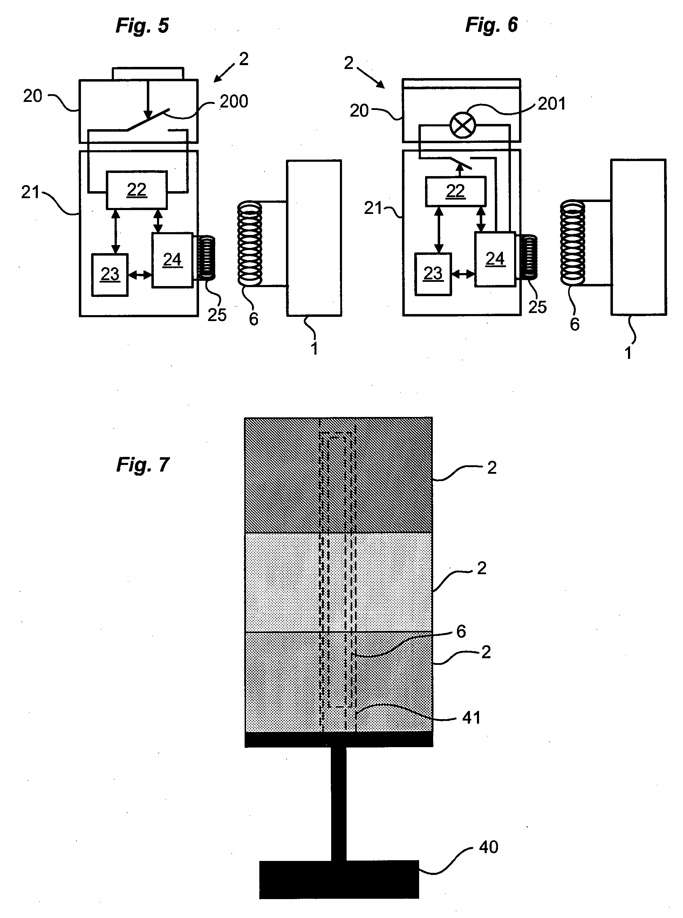

En effet, en référence à la figure 5, une interface de dialogue homme-machine 20 de type bouton poussoir comporte par exemple un contact 200 dont l'état est surveillé en permanence par les moyens de traitement 22 de l'étiquette électronique 21. Lorsque le contact change d'état, les moyens de traitement 22 de l'étiquette électronique 21 écrivent des données représentatives de cet état dans sa mémoire interne 23. La station de lecture/écriture 1 qui scrute à intervalles réguliers la mémoire 23 de l'étiquette 21 peut alors être informée du changement d'état de l'interface de dialogue homme-machine 20.

En référence à la figure 6, une interface de dialogue homme-machine 20 de type voyant lumineux comporte par exemple une diode électroluminescente 201 susceptible d'être alimentée par l'étiquette électronique 21. Lorsque la station 1 commande l'allumage du voyant, elle écrit dans la mémoire 23 interne de l'étiquette des données représentatives de l'état qu'elle souhaite donner au voyant lumineux, par exemple des données représentatives de l'état "allumé" du voyant. Les moyens de traitement 22 de l'étiquette qui lisent la mémoire 23 détectent le changement d'état et commandent l'actionnement d'un contact pour connecter la diode 201 aux moyens de stockage d'énergie 24 connectés à l'antenne 25 de l'étiquette. Le voyant est alors alimenté directement par l'énergie captée grâce à l'antenne 25 de l'étiquette 21.

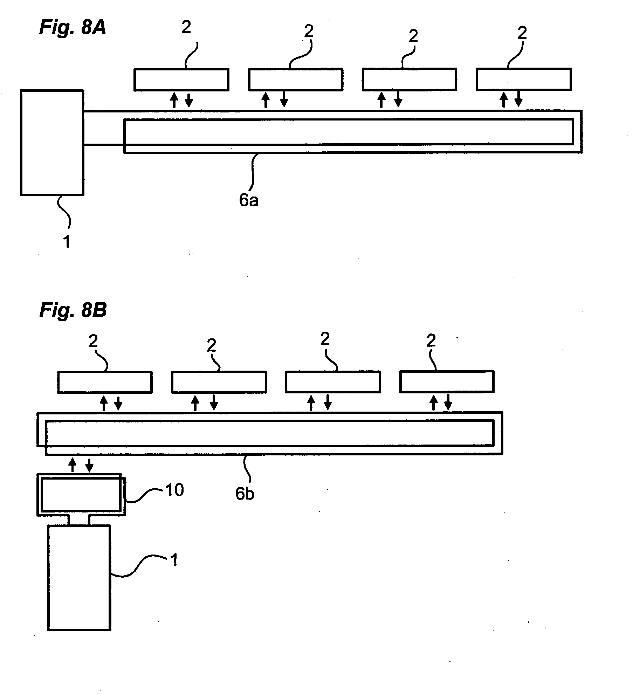

Par ailleurs, l'un des principes de l'invention consiste à employer une antenne 6a, 6b qui est externe à la station 1. Comme représenté sur les figures 8A et 8B, l'antenne externe qui est employée peut être connectée directement à la station (figure 8A) de lecture/écriture ou couplée magnétiquement à la station (figure 8B). Le brevet FR2896898 décrit plus précisément l'architecture de l'antenne et différentes configurations de fonctionnement.

Selon l'invention, l'antenne 6 employée présente une forme déterminée permettant de ménager une surface de couplage suffisante pour une ou plusieurs étiquettes électroniques 21 situées à proximité. La forme de l'enroulement utilisée pour l'antenne 6 peut indifféremment s'adapter aux différentes configurations du système : ces formes peuvent être par exemple sensiblement circulaires, elliptiques, rectangulaires, et même présenter des profils plus complexes. Sur les figures annexées, l'antenne a été choisie avec une forme générale rectangulaire et allongée de manière à pouvoir être en couplage magnétique avec plusieurs étiquettes électroniques positionnées de manière adjacente le long de l'antenne.

Dans la première configuration représentée sur la figure 8A, l'antenne 6a n'est pas directement intégrée à l'intérieur du boîtier de la station 10, mais déportée et reliée au boîtier de la station 10 par un câble électrique.

Sur la figure 8B, l'antenne 6b se présente en fait sous la forme d'un prolongateur d'antenne passif qui n'est pas connecté électriquement avec la station ou l'étiquette mais qui est en couplage magnétique avec une antenne 10 intégrée ou connectée à la station. De manière connue mais non visible sur les figures annexées, ce prolongateur pourra comporter un premier enroulement connecté en série avec un second enroulement. Le premier enroulement est par exemple de taille différente du second enroulement et est positionné à proximité de l'antenne de la station, c'est-à-dire dans le champ d'action de la station, de manière à créer un couplage magnétique entre l'antenne de la station 10 et le premier enroulement, lorsque la station émet un signal électromagnétique. Ainsi, lorsqu'une étiquette électronique RFID est disposée à proximité du second enroulement du prolongateur, c'est-à-dire dans le champ d'action du second enroulement, alors il y a couplage magnétique entre l'antenne de l'étiquette électronique et le second enroulement. Dans ce cas, comme les enroulements du prolongateur sont connectés en série, un signal électromagnétique émis par l'antenne se propage par couplage magnétique dans le premier enroulement, puis circule dans le second enroulement avant de se propager par couplage magnétique dans l'antenne de l'étiquette. De même, un signal électromagnétique émis par l'antenne 25 de l'étiquette 21 sera reçu par l'antenne 6b de la station, via les deux enroulements.

A partir des différents éléments décrits ci-dessus, l'invention consiste donc à réaliser un système de dialogue homme-machine employant la technologie RFID entre plusieurs organes de dialogue homme-machine 2 et une station de lecture/écriture 1 de type RFID. L'invention s'applique notamment aux systèmes de dialogue homme-machine qui peuvent être positionnés sur la porte d'une armoire. Le système de l'invention peut ainsi remplacer des boutons ou voyants montés chacun individuellement sur la porte de l'armoire.

Pour cela, dans un premier mode de réalisation représenté sur les figures 1 à 4, l'invention consiste à diviser le système de dialogue homme-machine en deux parties distinctes. Une première partie est constituée de la station de lecture/écriture 1 RFID et une seconde partie est constituée d'un support 3 de fixation intégrant l'antenne 6 et capable d'accueillir de manière amovible et interchangeable plusieurs organes de dialogue homme-machine 2 conformes à ceux décrits ci-dessus.

Selon l'invention, la station 1 et le support de fixation 3 sont donc destinés à être positionnés de part et d'autre d'une paroi 5, telle que par exemple la paroi d'une armoire électrique. La station 1 sera disposée à l'intérieur de l'armoire, contre une face de la paroi 5 et le support sera disposé à l'extérieur de l'armoire sur la face opposée de la paroi 5. La configuration employée entre la station et l'antenne étant celle de la figure 8B, le support 3 est positionné sur la face de la paroi 5 de manière à placer l'antenne 6 en couplage magnétique avec la station 1 qui est fixée sur la face opposée de la paroi 5. La station 1 et le support de fixation 3 des organes de dialogue homme-machine 2 présentent par exemple des moyens de fixation coopérant entre eux à travers la paroi 5. En référence aux figures 3 et 4, le support 3 comporte par exemple deux organes de fixation, par exemple deux goupilles 32, 33. Chaque goupille 32, 33 est destinée à traverser un orifice 50, 51 réalisé à travers la paroi 5 et à venir s'insérer à son extrémité libre dans une ouverture 12, 13 complémentaire réalisée sur la station 1. Selon l'invention, seuls deux orifices 50, 51 peuvent donc être nécessaires pour fixer le support 3 à travers la paroi 5, le support 3 pouvant accueillir lui-même plusieurs organes de dialogue homme-machine 2. Cette configuration de l'invention présente donc notamment l'avantage de minimiser le nombre d'orifices à percer à travers la paroi 5.

Sur les figures 1 à 4, le support de fixation 3 a par exemple la forme d'une plaquette 30. La plaquette comporte par exemple deux glissières 300 parallèles sur lesquelles il est possible de venir enfiler successivement plusieurs organes de dialogues homme-machine 2 tels que définis ci-dessus. Un élément formant un bouchon 31 permet de venir refermer l'entrée de la plaquette 30 par laquelle les organes de dialogue homme-machine 2 sont enfilés. Sur les figures 1 à 4, le support 3 peut par exemple accueillir cinq organes de dialogue homme-machine 2. Les organes de dialogue homme-machine 2 compatibles avec le support 3 présentent tous un boîtier ayant une forme externe identique, par exemple parallélépipédique. Ils se distinguent entre eux par leur(s) interface(s) de dialogue homme-machine 20. En référence aux figures 1 à 4, ils peuvent par exemple comporter à la fois une interface de commande de type bouton-poussoir et une interface de signalisation de type étiquette lumineuse.

Le support 3 de l'invention présente l'avantage d'intégrer l'antenne 6 destinée à réaliser le couplage magnétique entre les organes de dialogue homme-machine 2 situés au-dessus et la station 1 située au-dessous. Le support 3 comporte notamment un blindage agencé pour confiner au maximum le champ magnétique généré et limiter ainsi la zone de dialogue de la station. Le blindage permet donc de limiter l'application du champ magnétique émis grâce à l'antenne 6 aux organes de dialogue homme-machine 2 positionnés sur le support 3. En référence aux figures 3A, 3B et 4, le blindage est constitué d'au moins une pièce-écran principale 34 et de pièces-écrans secondaires 35 adaptées à la fréquence de la porteuse. Ces pièces-écrans 34, 35 sont par exemple constituées chacune d'une pièce conductrice magnétique enveloppée d'une couche en matériau conducteur. La pièce-écran 34 principale est intégrée au support 3 et s'étend le long du support 3 au-dessous de l'antenne 6 tandis que les pièces-écrans secondaires 35 sont chacune intégrées à un organe de dialogue homme-machine 2 et agencées dans chaque organe de dialogue homme-machine au-dessus du circuit imprimé 26.

Une variante de réalisation du système de dialogue homme-machine de l'invention, représentée en figure 7, consiste à réaliser une colonne lumineuse dans laquelle le support comporte par exemple un socle 40 dans lequel est logée la station 1 et une tige 41 sur laquelle sont enfilés des organes de dialogue homme-machine 2 ayant chacun une interface de dialogue homme-machine de type organe de signalisation lumineux. L'antenne 6 est par exemple reliée directement à la station selon la configuration représentée en figure 8A et est logée dans la tige 41 du support, le long de celle-ci de manière à pouvoir assurer le couplage magnétique entre chaque organe de dialogue homme-machine 2 et la station 1. Grâce à cette variante, il est possible de pouvoir échanger facilement un organe de signalisation de la colonne sans opération de câblage particulière.

Le système de l'invention présente donc un certain nombre d'avantages dont certains sont listés ci-dessous :
- Réduction du nombre de trous à percer à travers la paroi,
- Possibilité de configurer le système, même après la fixation du support,
- Possibilité de modifier le système à tout moment en enlevant, en ajoutant ou en échangeant des organes de dialogue homme-machine,
- Limitation du câblage car il n'est plus nécessaire de câbler individuellement chaque organe de dialogue homme-machine,
- Possibilité d'intégrer le système à un réseau en connectant directement la station sur le réseau,
- Modularité du système et richesse des fonctions proposées...

## Revendications

1. Système de dialogue homme-machine comportant :
- une station de lecture/écriture de type RFID (1) incluant notamment des moyens de traitement de données,
- une antenne (6) connectée ou couplée magnétiquement à la station de lecture/écriture (1),
- plusieurs organes de dialogue homme-machine (2) comportant chacun une interface de dialogue homme-machine (20) et une étiquette électronique (21),
- l'étiquette électronique (21) étant dotée d'une mémoire (23) interne et de moyens de traitement (22) et étant positionnée de manière à être alimentée par couplage magnétique par la station de lecture/écriture (1) et à communiquer sans contact par couplage magnétique avec la station de lecture/écriture,
- la mémoire (23) interne de l'étiquette électronique (21) stocke des données représentatives d'un état de l'organe de dialogue homme-machine (2),
- la station (1) comporte des moyens de lecture/écriture de la mémoire (23) interne de l'étiquette électronique (21),
**caractérisé en ce que** :
- le système comporte un support de fixation (3) destiné à accueillir chaque organe de dialogue homme-machine (2) de manière amovible et interchangeable.

2. Système selon la revendication 1, **caractérisé en ce qu'**un des organes de dialogue homme-machine (2) comporte une interface de commande actionnable par un utilisateur et coopérant avec les moyens de traitement (22) de l'étiquette électronique (21) pour écrire des données représentatives de l'état de l'organe de dialogue homme-machine (2) dans la mémoire (23) de l'étiquette électronique.

3. Système selon la revendication 1, **caractérisé en ce qu'**un des organes de dialogue homme-machine (2) comporte une interface de signalisation connectée à l'étiquette (21) de manière à pouvoir être alimentée par le couplage magnétique existant entre la station (1) et l'étiquette (21) et coopérant avec les moyens de traitement (22) de l'étiquette électronique (21) pour afficher l'état correspondant aux données stockées dans la mémoire (23) interne de l'étiquette électronique.

4. Système selon la revendication 1, **caractérisé en ce qu'**un des organes de dialogue homme-machine (2) comporte une interface d'identification ou de détection coopérant avec les moyens de traitement (22) de l'étiquette électronique pour écrire des données représentatives de l'état de l'organe de dialogue homme-machine (2) dans la mémoire (23) de l'étiquette électronique.

5. Système selon la revendication 1, **caractérisé en ce que** l'antenne (6) est intégrée au support de fixation (3).

6. Système selon la revendication 5, **caractérisé en ce que** le support de fixation (3) comporte un blindage agencé pour limiter la zone de dialogue existant entre la station (1) et les étiquettes électroniques (21).

7. Système selon l'une des revendications 1 à 6, **caractérisé en ce que** le support de fixation (3) et la station (1) sont positionnés de part et d'autre d'une paroi (5).

8. Système selon l'une des revendications 1 à 7, **caractérisé en ce que** le support de fixation (3) comporte une plaquette (30) destinée à recevoir par coulissement plusieurs organes de dialogue homme-machine (2).

9. Système selon l'une des revendications 1 à 6, **caractérisé en ce que** le support de fixation comporte une tige (41) sur laquelle sont enfilés les organes de dialogue homme-machine (2).

10. Système selon l'une des revendications 1 à 9, **caractérisé en ce que** le système comporte un ensemble (7) comprenant un organe d'émission/réception sans-fil de données et une étiquette électronique, ledit ensemble étant apte à être positionné sur le support de fixation (3).

## Patentansprüche

1. Mensch/Maschine-Dialogsystem, das Folgendes umfasst:
- eine Lese/Schreib-Station des RFID-Typs (1), die insbesondere Datenverarbeitungsmittel enthält,
- eine Antenne (6), die mit der Lese/Schreib-Station (1) verbunden oder magnetisch gekoppelt ist,
- mehrere Mensch/Maschine-Dialogorgane (2), die jeweils eine Mensch/Maschine-Dialogschnittstelle (20) und ein elektronisches Etikett (21) enthalten,
- wobei das elektronische Etikett (21) mit einem internen Speicher (23) und mit Verarbeitungsmitteln (22) versehen ist und in der Weise positioniert ist, dass es durch magnetische Kopplung durch die Lese/Schreib-Station (1) versorgt wird und kontaktlos durch magnetische Kopplung mit der Lese/Schreib-Station kommuniziert,
- wobei der interne Speicher (23) des elektronischen Etiketts (21) Daten speichert, die für einen Zustand des Mensch/Maschine-Dialogorgans (2) repräsentativ sind,
- wobei die Station (1) Mittel zum Lesen/Beschreiben des internen Speichers (23) des elektronischen Etiketts (21) umfasst,
**dadurch gekennzeichnet, dass**:
- das System einen Befestigungsträger (3) umfasst, der dazu bestimmt ist, jedes Mensch/Maschine-Dialogorgan (2) entnehmbar und austauschbar aufzunehmen.

2. System nach Anspruch 1, **dadurch gekennzeichnet, dass** eines der Mensch/Maschine-Dialogorgane (2) eine Steuerschnittstelle umfasst, die durch einen Anwender betätigbar ist und mit den Verarbeitungsmitteln (22) des elektronischen Etiketts (21) zusammenwirkt, um Daten, die für den Zustand des Mensch/Maschine-Dialogorgans (2) repräsentativ sind, in den Speicher (23) des elektronischen Etiketts zu schreiben.

3. System nach Anspruch 1, **dadurch gekennzeichnet, dass** eines der Mensch/Maschine-Dialogorgane (2) eine Signalgebungsschnittstelle umfasst, die mit dem Etikett (21) in der Weise verbunden ist, dass sie durch magnetische Kopplung, die zwischen der Station (1) und dem Etikett (21) vorhanden ist, versorgt werden kann, und mit den Verarbeitungsmitteln (22) des elektronischen Etiketts (21) zusammenwirkt, um den Zustand, der den im internen Speicher (23) des elektronischen Etiketts gespeicherten Daten entspricht, anzuzeigen.

4. System nach Anspruch 1, **dadurch gekennzeichnet, dass** eines der Mensch/Maschine-Dialogorgane (2) eine Identifizierungs- oder Detektionsschnittstelle umfasst, die mit den Verarbeitungsmitteln (22) des elektronischen Etiketts zusammenwirkt, um Daten, die den Zustand des Mensch/Maschine-Dialogorgans (2) repräsentieren, in den Speicher (23) des elektronischen Etiketts zu schreiben.

5. System nach Anspruch 1, **dadurch gekennzeichnet, dass** die Antenne (6) in den Befestigungsträger (3) integriert ist.

6. System nach Anspruch 5, **dadurch gekennzeichnet, dass** der Befestigungsträger (3) eine Abschirmung umfasst, die dafür ausgelegt ist, die Dialogzone, die zwischen der Station (1) und den elektronischen Etiketten (21) vorhanden ist, zu begrenzen.

7. System nach einem der Ansprüche 1 bis 6, **dadurch gekennzeichnet, dass** der Befestigungsträger (3) und die Station (1) beiderseits einer Wand (5) positioniert sind.

8. System nach einem der Ansprüche 1 bis 7, **dadurch gekennzeichnet, dass** der Befestigungsträger (3) ein Plättchen (30) umfasst, das dazu bestimmt ist, mehrere Mensch/Maschine-Dialogorgane (2) gleitend aufzunehmen.

9. System nach einem der Ansprüche 1 bis 6, **dadurch gekennzeichnet, dass** der Befestigungsträger einen Stift (41) umfasst, auf den die Mensch/Maschine-Dialogorgane (2) gewickelt sind.

10. System nach einem der Ansprüche 1 bis 9, **dadurch gekennzeichnet, dass** das System eine Gesamtheit (7) umfasst, die ein Organ zum drahtlosen Senden/Empfangen von Daten und ein elektronisches Etikett enthält, wobei die Gesamtheit auf dem Befestigungsträger (3) positioniert werden kann.

## Claims

1. A human-machine dialog system comprising:
- an RFID type read/write station (1) notably including means of data processing,
- an antenna (6) magnetically connected or coupled with the read/write station (1),
- several human-machine dialog devices (2) each comprising a human-machine dialog interface (20) and an electronic tag (21),
- the electronic tag (21) being equipped with an internal memory (23) and processing means (22) and being positioned so as to be powered via magnetic coupling by the read/write station (1) and to be in contactless communication via magnetic coupling with the read/write station,
- the electronic tag's (21) internal memory (23) stores data representative of a state of the human-machine dialog device (2),
- the station (1) comprises read/write means for the electronic tag's (21) internal memory (23),
**characterized in that**:
- the system comprises a mounting support (3) intended to accommodate each human-machine dialog device (2) in a removable and interchangeable manner.

2. The system as claimed in claim 1, **characterized in that** one of the human-machine dialog devices (2) comprises a control interface operable by a user and cooperating with the processing means (22) of the electronic tag (21) for writing data representative of the state of the human-machine dialog device (2) in the electronic tag's memory (23).

3. The system as claimed in claim 1, **characterized in that** one of the human-machine dialog devices (2) comprises a signaling interface connected to the tag (21) so as to be able to be powered via the magnetic coupling existing between the station (1) and the tag (21) and cooperating with the electronic tag's (21) processing means (22) for displaying the state corresponding to the data stored in the electronic tag's internal memory (23).

4. The system as claimed in claim 1, **characterized in that** one of the human-machine dialog devices (2) comprises an identification or detection interface cooperating with the electronic tag's processing means (22) for writing data representative of the state of the human-machine dialog device (2) in the electronic tag's memory (23).

5. The system as claimed in claim 1, **characterized in that** the antenna (6) is integrated into the mounting support (3).

6. The system as claimed in claim 5, **characterized in that** the mounting support (3) comprises a shielding arranged to limit the dialog area existing between the station (1) and the electronic tags (21).

7. The system as claimed in one of claims 1 to 6, **characterized in that** the mounting support (3) and the station (1) are positioned on each side of a wall (5).

8. The system as claimed in one of claims 1 to 7, **characterized in that** the mounting support (3) comprises a plate (30) intended to receive several human-machine dialog devices (2) by sliding.

9. The system as claimed in one of claims 1 to 6, **characterized in that** the mounting support comprises a rod (41) on which the human-machine dialog devices (2) are slipped.

10. The system as claimed in one of claims 1 to 9, **characterized in that** the system comprises an assembly (7) including a wireless data transmitting/receiving device and an electronic tag, said assembly being capable of being positioned on the mounting support (3) .
